Europäisches Patentamt

European Patent Office

Office européen des brevets

(19)

(11) Veröffentlichungsnummer: **0 060 336**
**A2**

(12) **EUROPÄISCHE PATENTANMELDUNG**

(21) Anmeldenummer: 81109257.6

(22) Anmeldetag: 29.10.81

(51) Int. Cl.³: **H 03 K 17/04,** H 03 K 17/687,
H 02 M 3/335

(30) Priorität: 05.03.81 DE 3108385

(43) Veröffentlichungstag der Anmeldung: 22.09.82
Patentblatt 82/38

(84) Benannte Vertragsstaaten: **AT BE CH DE FR IT LI NL**

(71) Anmelder: **SIEMENS AKTIENGESELLSCHAFT Berlin
und München, Postfach 22 02 61,
D-8000 München 22 (DE)**

(72) Erfinder: **Bete, Manfred, Würzburger Ring 45,
D-8520 Erlangen (DE)**

(54) **Verfahren zur Ansteuerung eines Leistungs-Feldeffekt-Schalttransistors und Schaltungsanordnungen zur Durchführung
des Verfahrens.**

(57) Zum Einschalten eines Leistungs-Feldeffekt-Schalttransistors (T1) wird die Gate-Source-Kapazität durch Zuschalten eines Kondensators (C1) über einen ersten Transistor (T2, T3) aufgeladen. Zum Ausschalten des Leistungs-Feldeffekt-Schalttransistors (T1) wird die Gate-Source-Kapazität durch Einschalten eines zweiten Transistors (T3, T2) entladen. Damit erfolgt sowohl der Aufladevorgang als auch der Entladevorgang niederohmig, so daß er jeweils in kurzer Zeit abläuft. Infolgedessen werden die Schaltzeiten und somit auch Ein- bzw. Ausschaltverluste des Leistungs-Feldeffekt-Schalttransistors (T1) gering gehalten. Dabei ist weder eine gesonderte Hilfsspannungsquelle erforderlich, noch werden induktive Elemente benötigt.

EP 0 060 336 A2

0060336

Unser Zeichen
VPA 81 P 3025 E

SIEMENS AKTIENGESELLSCHAFT
Berlin und München

Verfahren zur Ansteuerung eines Leistungs-Feldeffekt-Schalttransistors und Schaltungsanordnungen zur Durchführung des Verfahrens

Die Erfindung betrifft ein Verfahren zur Ansteuerung eines Leistungs-Feldeffekt-Schalttransistors und Schaltungsanordnungen zur Durchführung des Verfahrens.

Die Schaltzeiten von Feldeffekttransistoren werden durch die Auf- bzw. Entladezeit der Gate-Source-Kapazität des Transistors bestimmt. Insbesondere bei Leistungs-Feldeffekt-Transistoren nimmt diese Kapazität beachtliche Werte an. Um die Verluste beim Ein- und Ausschaltvorgang gering zu halten, werden möglichst kurze Schaltzeiten angestrebt. Dazu benötigt man Ansteuerschaltungen, die hohe Impulsströme liefern. Bei handelsüblichen Ansteuerschaltungen werden diese hohen Impulsströme von einer gesonderten Hilfsspannungsquelle erzeugt. Dies ist jedoch mit einem verhältnismäßig hohen Aufwand verbunden.

Aufgabe der Erfindung ist es daher, ein Verfahren zur Ansteuerung eines Leistungs-Feldeffekt-Schalttransistors und Schaltungen zur Durchführung des Verfahrens so auszugestalten, daß hohe Impulsströme für die Ansteuerung ohne gesonderte Hilfsspannungsquellen erzeugt werden.

Diese Aufgabe wird erfindungsgemäß dadurch gelöst, daß zum Einschalten des Leistungs-Feldeffekt-Schalttransistors seine Gate-Source-Kapazität durch Zuschalten eines Kondensators über einen ersten Transistor aufgeladen wird und daß zum Ausschalten des Leistungs-Feldeffekt-Schalttransistors die Gate-Source-Kapazität durch Einschalten eines zweiten Transistors entladen wird.

Sid 2 Bih/26.02.1981

0060336

Durch das Aufladen der Gate-Source-Kapazität über einen
Kondensator und das Entladen unmittelbar über einen
zweiten Transistor können hohe Impulsströme auch ohne
gesonderte Hilfsspannungsquellen erzeugt werden. Dabei
sind auch keine aufwendige induktive Bauelemente erforderlich.

Bei einer Schaltungsanordnung zur Durchführung des Verfahrens, bei der eine erste Eingangsklemme über die
Drain-Source-Strecke eines über einen Ansteuertransistor
angesteuerten Leistungs-Feldeffekt-Schalttransistors vom
N-Kanal-Typ mit einer ersten Ausgangsklemme und eine
zweite Eingangsklemme mit einer zweiten Ausgangsklemme
verbunden ist, ist vorteilhafterweise die Drain-Source-
Strecke des Leistungs-Feldeffekt-Schalttransistors von
der Reihenschaltung einer Diode, deren Anode mit der dem
Pluspol der Versorgungsspannungsquelle zugeordneten ersten
Eingangsklemme verbunden ist, und des Kondensators überbrückt; der Verbindungspunkt von Diode und Kondensator
über die Schaltstrecke eines Hilfstransistors mit dem
Gate des Leistungs-Feldeffekt-Schalttransistors verbunden; der Steueranschluß des Hilfstransistors über
einen Widerstand mit dem Verbindungspunkt von Diode und
Kondensator und über die Schaltstrecke eines Ansteuertransistors mit der zweiten Eingangsklemme verbunden und
zwischen dem Steueranschluß des Hilfstransistors und
dem Verbindungspunkt der Steuerstrecke des Hilfstransistors mit dem Gate des Leistungs-Feldeffekt-Schalttransistors ein Widerstand angeordnet. Mit dieser Schaltungsanordnung kann das erfindungsgemäße Verfahren auf einfache Weise für Leistungs-Feldeffekt-Schalttransistoren
vom N-Kanal-Typ realisiert werden.

Bei einer Schaltungsanordnung zur Durchführung des erfindungsgemäßen Verfahrens, bei der eine erste Eingangsklemme über die Drain-Source-Strecke eines über einen
Ansteuertransistor angesteuerten Leistungs-Feldeffekt-

0060336

Schalttransistors vom P-Kanal-Typ mit einer ersten Ausgangsklemme und eine zweite Eingangsklemme mit einer zweiten Ausgangsklemme verbunden ist, kann vorteilhafterweise zwischen Source und Gate des Leistungs-Feldeffekt-Schalttransistors die Reihenschaltung eines von einem Widerstand überbrückten Kondensators und der Schaltstrecke eines Hilfstransistors liegen, wobei der Kondensator mit dem Gate des Leistungs-Feldeffekt-Schalttransistors verbunden ist; der Verbindungspunkt von Kondensator und Hilfstransistor über eine Diode und die Schaltstrecke des Ansteuertransistors mit der zweiten Eingangsklemme verbunden sein und der Steueranschluß des Hilfstransistors mit dem Verbindungspunkt von Diode und Ansteuertransistor und über einen Widerstand mit der ersten Eingangsklemme verbunden sein. Damit kann das erfindungsgemäße Verfahren auf einfache Weise für Leistungs-Feldeffekt-Schalttransistoren vom P-Kanal-Typ realisiert werden.

Vorteilhafterweise sind Hilfstransistor und Ansteuertransistor Feldeffekttransistoren. Damit wird die erforderliche Ansteuerleistung sehr gering gehalten.

Die Gate-Source-Strecke des Leistungs-Feldeffekt-Schalttransistors ist zweckemäßigerweise ebenso wie die Gate-Source-Strecke des Hilfstransistors von je einer Z-Diode überbrückt. Damit werden die Gate-Source-Strecken der Transistoren gegen Überspannungen geschützt. Bei der Schaltungsanordnung für Leistungs-Feldeffekt-Schalttransistoren vom P-Kanal-Typ wird dies auch erreicht, wenn die Diode eine Z-Diode ist.

Zur Schaltstrecke des Hilfstransistors ist zweckmäßigerweise ein Widerstand in Reihe geschaltet. Damit wird dieser bei der Auf- bzw. Entladung der Gate-Source-Kapazität des Leistungs-Feldeffekt-Schalttransistors vor Überströmen geschützt.

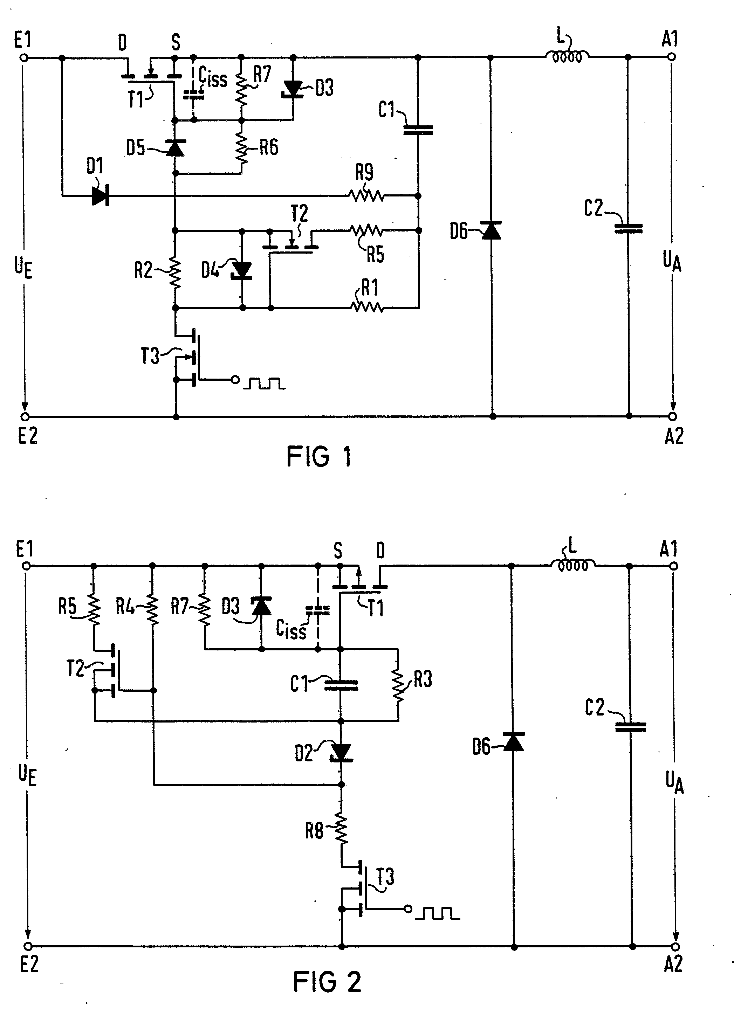

Ausführungsbeispiele der Erfindung werden nachfolgend anhand der Figuren 1 und 2 dargestellt.

Fig. 1 zeigt eine Ansteuerschaltung für einen Leistungs-Feldeffekt-Schalttransistor T1 vom N-Kanal-Typ. In diesem Fall ist ein Feldeffekt-Transistor vom Anreicherungstyp eingesetzt. Der Leistungs-Feldeffekt-Schalttransistor T1, im folgenden kurz als Leistungs-Fet bezeichnet, verbindet eine Eingangsklemme E1 über eine Drossel L mit der Ausgangsklemme A2, während die Eingangsklemme E2 mit der Ausgangsklemme A2 verbunden ist. Die Ausgangsklemmen A1, A2 sind von einem Glättungskondensator C2 überbrückt und zwischen dem Verbindungspunkt von Leistungs-Fet T1 und der Drossel L und der Ausgangsklemme A2 liegt eine Freilaufdiode D6, deren Anode der Ausgangsklemme A2 zugewandt ist. An den Eingangsklemmen E1, E2 steht eine Versorgungsspannung $U_E$ an, deren Pluspol an der Eingangsklemme E1 anliegt. Mit dieser Schaltung wird ein Schaltregler realisiert, wenn man den Leistungs-Fet T1 periodisch ansteuert. Die zwischen den Ausgangsklemmen A1, A2 anstehende Ausgangsspannung kann durch Veränderung des Tastverhältnisses des Leistungs-Fets T1 beeinflußt werden. Während der Ausschaltzeit des Leistungs-Fets T1 fließt der Strom der Drossel L über die Freilauf-Diode D6.

Im folgenden soll nun die Ansteuerschaltung für den Leistungs-Fet T1 beschrieben werden. Das Gate des Leistungs-Fets T1 ist über die Reihenschaltung einer Diode D5, eines Widerstands R2 und der Drain-Source-Strecke eines Ansteuer-Feldeffekt-Transistors T3 mit der Eingangsklemme E2 verbunden. Dabei ist die Kathode der Diode D5 dem Gate des Leistungs-Fets T1 zugewandt. Die Gate-Source-Strecke des Leistungs-Fets T1 ist mit der Parallelschaltung eines Widerstands R7 und einer Z-Diode D3 überbrückt. Dabei ist die Anode der Z-Diode D3 dem Source-Anschluß des Leistungs-Fets T1 zugewandt. Die Diode D5 ist von einem Widerstand R6 überbrückt.

Die Drain-Source-Strecke des Leistungs-Fets T1 ist von der Reihenschaltung einer Diode D1, eines Widerstands R9 und eines Kondensators C1 überbrückt. Dabei ist die Anode der Diode D1 dem Drain-Anschluß des Leistungs-Fets T1 zugewandt. Der Verbindungspunkt von Widerstand R9 und Kondensator C1 ist über einen Widerstand R5 und die Drain-Source-Strecke eines Hilfs-Feldeffekt-Transistors T2 mit dem Verbindungspunkt von Widerstand R2 und Diode D5 verbunden. Der Gate-Anschluß des Hilfs-Fets T2 ist mit dem Drain-Anschluß des Ansteuer-Fets T3 und über einen Widerstand R1 mit dem Verbindungspunkt von Widerstand R9 und Kondensator C1 verbunden. Die Gate-Source-Strecke des Hilfs-Fets T2 ist von einer Z-Diode D4 überbrückt, deren Anode am Source-Anschluß des Hilfs-Fets T2 liegt.

Die Funktion der Ansteuerschaltung wird nachfolgend im Ablauf einer Taktperiode erläutert. Es wird zunächst davon ausgegangen, daß der Ansteuer-Fet T3 leitet. Damit sperrt der Leistungs-Fet T1, da sein Gate über die Widerstände R6 und R2 sowie die Drain-Source-Strecke des Ansteuer-Fets T3 auf Null-Potential liegt. Ebenso sperrt der Hilfs-Fet T2, da dessen Gate über die Drain-Source-Strecke des Ansteuertransistors T3 ebenfalls auf Null-Potential liegt. Während der Sperrzeit des Leistungs-Fets T1 steht an der Reihenschaltung von Diode D1, Widerstand R9 und Kondensator C1 nahezu die volle Eingangsspannung an, da die Freilaufdiode D6 geflutet ist und somit deren Kathode nahezu auf Null-Potential liegt. Der Kondensator C1 kann sich also aufladen, wobei der Widerstand R9 eine Beschädigung der Diode D1 durch zu hohe Aufladeströme verhindert. Die Aufladung des Kondensators C1 erfolgt auf die vom Spannungsteiler R9, R1 vorgegebene Spannung $U_E \cdot R1 / (R1+R9)$.

Um den Leistungs-Fet T1 einzuschalten, wird der Ansteuer-Fet T3 gesperrt. Damit wird über den relativ hochohmigen Widerstand R1 die Spannung am Drain-Anschluß des Ansteuer-Fets T3 und damit auch die Gate-Spannung des Hilfs-Fets T2 soweit angehoben, daß der Hilfs-Fet T2 leitet. Damit wird die in Fig. 1 gestrichelt eingezeichnete Gate-Source-Kapazität $C_{iss}$ des Leistungs-Fets T1 durch den Kondensator C1 über den Widerstand R5 und den Hilfs-Fet T2 sowie die Diode D5 aufgeladen und der Leistungs-Fet T1 leitet. Der Widerstand R5 ist verhältnismäßig niederohmig und soll lediglich den Ladestrom auf zulässige Werte begrenzen.

Damit wird der Einschaltvorgang des Leistungs-Fets T1 sehr kurz und die Verlustleistung während des Einschaltens bleibt klein. Die Schaltzeiten des Ansteuer-Fets T3 und des Hilfs-Fets T2 sind im Verhältnis zur Ansteuerzeit des Leistungs-Fets T1 zu vernachlässigen, da die Gate-Source-Kapazität dieser Fets wegen der kleinen Leistung gering ist.

Beim Übergang in den leitenden Zustand steigt das Source-Potential des Leistungs-Fets und damit das Potential des dem Gate des Leistungs-Fets T1 zugewandten Anschlusses des Kondensators C1 über die Eingangsspannung an. Damit wird der Leistungs-Fet T1 im leitenden Zustand gehalten.

Wenn nun der Leistungs-Fet T1 wieder gesperrt werden soll, so wird der Ansteuer-Fet T3 in den leitenden Zustand gesteuert. Damit entlädt sich die Gate-Source-Kapazität des Leistungs-Fets T1 über den Widerstand R6, die Parallelschaltung von Widerstand R2 und Z-Diode D4 sowie die Drain-Source-Strecke des Ansteuer-Fets T3. Der Widerstand R6 dient lediglich zur Strombegrenzung und weist daher kleine Werte auf, so daß auch der Entladevorgang schnell erfolgt. Damit wird auch die Ausschaltzeit des Leistungs-Fets T1 kurz und die Ausschaltverluste bleiben gering.

Die Z-Dioden D3 und D4 begrenzen die Gate-Source-Spannung des Leistungs-Fets T1 bzw. des Hilfs-Fets T2 auf zulässige Werte. Die Diode D1 verhindert die Entladung des Kondensators C1 über den Widerstand R9 während der Leitzeit des Leistungs-Fets T1. Über die Z-Diode D3 bzw. den Widerstand R7 kann sich der Kondensator C1 auch aufladen, wenn der Laststrom Null ist.

Eine entsprechende Schaltung für einen Leistungs-Fet T1 vom P-Kanal-Typ ist in Fig. 2 dargestellt. Auch hierbei handelt es sich um einen Schaltregler. Der Gate-Anschluß des Leistungs-Fets T1 ist über die Reihenschaltung eines Kondensators C1, einer Z-Diode D2, eines Widerstandes R8 und der Drain-Source-Strecke des Ansteuer-Fets T3 mit dem Bezugspotential der Schaltungsanordnung verbunden. Dem Kondensator C1 ist ein Widerstand R3 parallel geschaltet.

Der Verbindungspunkt von Kondensator C1 und Z-Diode D2 ist über die Reihenschaltung der Drain-Source-Strecke eines Hilfs-Fets T2 und eines Widerstands R5 mit der Eingangsklemme E1 verbunden, an der das positive Versorgungspotential ansteht. Der Gate-Anschluß des Hilfs-Fets T2 ist direkt mit dem Verbindungspunkt von Z-Diode D2 und Widerstand R8 sowie über einen Widerstand R4 mit der Eingangsklemme E1 verbunden. Zwischen Source- und Gate-Anschluß des Leistungs-Fets T1 liegt die Parallelschaltung eines Widerstands R7 und einer Z-Dioden D3, deren Kathode dem Source-Anschluß des Leistungs-Fets T1 zugewandt ist.

Zur Erklärung der Funktionsweise wird zunächst davon ausgegangen, daß der Ansteuer-Fet T3 eingeschaltet ist. Dann fließt ein Ansteuerstrom über die gestrichelt eingezeichnete Gate-Source-Kapazität des Leistungs-Fets T1, den Kondensator C1, die Z-Diode D2, den Widerstand R8 und die Drain-Source-Strecke des Ansteuer-Fets T3. Damit wird die Gate-Source-Kapazität $C_{iss}$ des Leistungs-Fets T1 und des Kondensators C1 aufgeladen, wobei der Widerstand R8 zur Strombegrenzung dient. Der Widerstand R3 bestimmt dabei den Maximalwert der Ladespannung von C1. Während der Leitzeit des Leistungs-Fets T1 ist der Hilfs-Fet T2 gesperrt, da über die Z-Diode D2 ein Strom fließt.

Der Leistungs-Fet T1 kann gesperrt werden, indem der Ansteuer-Fet T3 ausgeschaltet wird. Damit wird über den Widerstand R4 die Gate-Source-Spannung soweit angehoben, daß der Hilfs-Fet T2 leitet. Damit kann sich die Gate-Source-Kapazität des Leistungs-Fets T1 und der Kondensator C1 über die Drain-Source-Strecke des Hilfs-Fets T2 und den Widerstand R5 entladen. Durch den aufgeladenen Kondensator C1 wird erreicht, daß das Gate des Leistungs-Fets T1 um die Dioden-Schwellspannung der Z-Diode D3 über dem Potential der Source liegt. Der Widerstand R5 dient lediglich als Begrenzungswiderstand für den Entladestrom und weist sehr kleine Werte auf, so daß der Entladevorgang schnell abläuft. Damit sperrt der Leistungs-Fet T1 nach kurzer Zeit, so daß die Ausschaltverluste gering bleiben.

Die Z-Dioden D2 und D3 begrenzen die Gate-Source-Spannungen des Hilfs-Fets T2 bzw. des Leistungs-Fets T1 auf zulässige Werte.

Zusammenfassend ist also festzustellen, daß mit den beschriebenen Schaltungen Leistungs-Fets sowohl vom N-Kanalals auch vom P-Kanal-Typ niederohmig angesteuert werden können, so daß Auf- bzw. Entladung der Gate-Source-Kapazität des Leistungs-Fets schnell ablaufen. Damit werden die Schaltzeiten und somit auch Ein- und Ausschaltverluste gering gehalten. Eine gesonderte Hilsspannungsquelle ist dabei nicht notwendig. Die Schaltungen kommen mit kapazitiven Elementen aus, die wesentlich kostengünstiger als induktive Elemente sind.

## Patentansprüche

1. Verfahren zur Ansteuerung eines Leistungs-Feldeffekt-Schalttransistors, d a d u r c h   g e k e n n -
z e i c h n e t ,   daß zum Einschalten des Leistungs-Feldeffekt-Schalttransistors (T1) seine Gate-Source-Kapazität durch Zuschalten eines Kondensators (C1) über einen ersten Transistor (T2, T3) aufgeladen wird und daß zum Ausschalten des Leistungs-Feldeffekt-Schalttransistors (T1) seine Gate-Source-Kapazität durch Einschalten eines zweiten Transistors (T3, T2) entladen wird.

2. Schaltungsanordnung zur Durchführung eines Verfahrens nach Anspruch 1, wobei eine erste Eingangsklemme über die Drain-Source-Strecke eines über einen Ansteuertransistor angesteuerten Leistungs-Feldeffekt-Schalttransistors vom N-Kanal-Typ mit einer ersten Ausgangsklemme und eine zweite Eingangsklemme mit einer zweiten Ausgangsklemme verbunden ist, d a d u r c h   g e -
k e n n z e i c h n e t ,   daß die Drain-Source-Strecke des Leistungs-Feldeffekt-Schalttransistors (T1) von der Reihenschaltung einer Diode (D1), deren Anode mit der dem Pluspol der Versorgungsspannungsquelle zugeordneten ersten Eingangsklemme (E1) verbunden ist, und des Kondensators (C1) überbrückt ist; daß der Verbindungspunkt von Diode (D1) und Kondensator (C1) über die Schaltstrecke eines Hilfstransistors (T2) mit dem Gate des Leistungs-Feldeffekt-Schalttransistors (T1) verbunden ist; daß der Steueranschluß des Hilfstransistors (T2) über einen Widerstand (R1) mit dem Verbindungspunkt von Diode (D1) und Kondensator (C1) und über die Schaltstrecke eines Ansteuertransistors (T3) mit der zweiten Eingangsklemme (E2) verbunden ist und daß zwischen dem Steueranschluß des Hilfstransistors (T2) und dem Verbindungspunkt der Steuerstrecke des Hilfstransistors (T2) mit dem Gate des Leistungs-Feldeffekt-Schalttransistors (T1) ein Widerstand (R2) angeordnet ist.

0060336

3. Schaltungsanordnung zur Durchführung eines Verfahrens nach Anspruch 1, wobei eine erste Eingangsklemme über die Drain-Source-Strecke eines über einen Ansteuertransistor angesteuerten Leistungs-Feldeffekt-Schalttransistors vom P-Kanal-Typ mit einer ersten Ausgangsklemme und eine zweite Eingangsklemme mit einer zweiten Ausgangsklemme verbunden ist, d a d u r c h  g e - k e n n z e i c h n e t , daß zwischen Source und Gate des Leistungs-Feldeffekt-Schalttransistors (T1) die Reihenschaltung des von einem Widerstand (R3) überbrückten Kondensators (C1) und der Schaltstrecke eines Hilfstransistors (T2) liegt, wobei der Kondensator (C1) mit dem Gate des Leistungs-Feldeffekt-Schalttransistors (T1) verbunden ist; daß der Verbindungspunkt von Kondensator (C1) und Hilfstransistor (T2) über eine Diode (D2) und die Schaltstrecke des Ansteuertransistors (T3) mit der zweiten Eingangsklemme (E2) verbunden ist und daß der Steueranschluß des Hilfstransistors (T2) mit dem Verbindungspunkt von Diode (D2) und Ansteuertransistor (T3) und über einen Widerstand (R4) mit der ersten Eingangsklemme (E1) verbunden ist.

4. Schaltungsanordnung nach Anspruch 2 oder 3, d a - d u r c h  g e k e n n z e i c h n e t , daß der Hilfstransistor (T2) ein Feldeffekt-Transistor ist.

5. Schaltungsanordnung nach einem der Ansprüche 2 bis 4, d a d u r c h  g e k e n n z e i c h n e t , daß der Ansteuertransistor (T3) ein Feldeffekt-Transistor ist.

6. Schaltungsanordnung nach einem der Ansprüche 2 bis 5, d a d u r c h  g e k e n n z e i c h n e t , daß die Gate-Source-Strecke des Leistungs-Feldeffekt-Schalttransistors (T1) von einer Z-Diode (D3) überbrückt ist.

0060336

7. Schaltungsanordnung nach einem der Ansprüche 2 bis 6, d a d u r c h   g e k e n n z e i c h n e t , daß die Gate-Source-Strecke des Hilfstransistors (T2) von einer Z-Diode (D4) überbrückt ist.

8. Schaltungsanordnung nach Anspruch 3, d a d u r c h g e k e n n z e i c h n e t , daß die Diode (D2) eine Z-Diode ist.

9. Schaltungsanordnung nach einem der Ansprüche 2 bis 8, d a d u r c h   g e k e n n z e i c h n e t , daß zur Schaltstrecke des Hilfstransistors (T2) ein Widerstand (R5) in Reihe geschaltet ist.

10. Schaltungsanordnung nach Anspruch 2, d a d u r c h g e k e n n z e i c h n e t , daß zwischen der Schaltstrecke des Hilfstransistors (T2) und dem Gate des Leistungs-Feldeffekt-Schalttransistors (T1) die Parallelschaltung eines Widerstandes (R6) und einer Diode (D5) angeordnet ist.

FIG 1

FIG 2